# EUROPÄISCHE PATENTSCHRIFT

(11) **EP 2 478 564 B1**
(45) Veröffentlichungstag und Bekanntmachung des Hinweises auf die Patenterteilung: **08.11.2017**
(21) Anmeldenummer: 10754749.9
(22) Anmeldetag: 17.09.2010
(51) Int. Cl.: H01L 31/02, H01L 31/0216, H01L 31/0224, H01L 31/048, H01L 31/068

(54) **KRISTALLINE SOLARZELLE SOWIE VERFAHREN ZUR HERSTELLUNG EINER SOLCHEN**
CRYSTALLINE SOLAR CELL AND METHOD FOR PRODUCING SAID TYPE OF SOLAR CELL
CELLULE SOLAIRE CRISTALLINE ET PROCÉDÉ DE PRODUCTION D'UNE TELLE CELLULE SOLAIRE

(30) Priorität: 18.09.2009 DE 102009044052
(43) Veröffentlichungstag der Anmeldung: 25.07.2012
(73) Patentinhaber: Fraunhofer Gesellschaft zur Förderung der angewandten Forschung e.V., 80686 München (DE)
(72) Erfinder: NAGEL, Henning, 63755 Alzenau (DE)
(86) Internationale Anmeldenummer: PCT/EP2010/063710
(87) Internationale Veröffentlichungsnummer: WO 2011/033070

(56) Entgegenhaltungen:
- EP-A2- 1 304 748
- WO-A1-2007/022955
- WO-A1-2008/072828
- WO-A1-2008/098407
- WO-A2-2008/115814
- US-A1- 2006 196 535
- US-A1- 2009 151 782

## Beschreibung

Die Erfindung bezieht sich auf eine kristalline Solarzelle mit einem p-grunddotierten Substrat und einem frontseitigen n-dötierten Bereich und einem rückseitigen p-dotieren Bereich, einem Frontseitenkontakt, einem Rückseitenkontakt und zumindest einer frontseitigen ersten Schicht aus SiN oder SiN enthaltend wie Antireflexiohsschicht. Auch nimmt die Erfindung Bezug auf ein Verfahren zur Herstellung einer kristallinen Solarzelle mit p-grunddotiertem Substrat und einem frontseitigen n-dotierten Bereich, rückseitigem p-dotierten Bereich, Front- und Rückseitenkontakten sowie zumindest einer frontseitigen Schicht aus SiN oder SiN enthaltend als erste Schicht wie Antireflexionsschicht.

Die n- und p-dotierten Bereiche in einer pn-Diode erzeugen eine Raumladungszone, in der Elektronen aus der n-Schicht in die p-Schicht und Löcher der p-Schicht in die n-Schicht wandern. Wenn eine Spannung an die sich auf den n- und p-dotierten Schichten befindenden metallischen Elektroden gelegt wird, fließt ein hoher Strom, wenn die Spannung an der negativen Elektrode negativ ist. Bei umgekehrter Polung fließt ein wesentlich geringerer Strom.

Eine besondere Ausführung von Si pn-Dioden sind Solarzellen oder Photodetektoren, bei denen ein Teil der Vorderseite mit einer mindestens teiltransparenten Schicht versehen ist, die meistens eine reflexionsmindennde Wirkung besitzt. Durch diese Schicht dringt Licht in das Silizium ein, welches dort zum Teil absorbiert wird. Dabei werden Überschusselektronen und -löcher freigesetzt. Die Überschusselektronen wandern im elektrischen Feld der Raumladungszone vom p-dotierten zum n-dotierten Bereich und schließlich zu den Metallkontakten auf dem n-dotierten Bereich, die Überschusslöcher wandern vom n-dotierten in den p-dotierten Bereich und schließlich zu den Metallköntakten auf dem p-dotierten Bereich. Wenn eine Last zwischen die positiven und negativen Elektroden gelegt wird, fließt ein Strom.

In der Regel werden viele Solarzellen mit Hilfe von metallischen Verbindern in Reihe geschaltet und in einem Solarmodul bestehend aus mehreren Isolationsschichten einlaminiert, um sie vor Witterungseinflüssen zu schützen. Ein Problem ist, dass durch die Reihenschaltung der Solarzellen und die Reihenschaltung mehrerer Module zu einem System regelmäßig Systemspannungen von mehreren hundert Volt auftreten. Es ergeben sich hohe elektrische Felder zwischen Solarzellen und Erdpotential, die zu unerwünschten Verschiebung- und Ableitströmen führen. Dadurch können Ladungen auf der Oberfläche der Solarzellen dauerhaft deponiert werden, die deren Wirkungsgrad erheblich reduzieren können. Auch unter Beleuchtung oder langer Lagerung im Dunkeln können sich Ladungen auf der Oberfläche anreichern.

Bekannt ist die Degradation der Leerlaufspannung und in geringerem Maß auch des Kurzschlussstroms aufgrund von Ladungen auf der Vorderseite von beidseitig kontaktierten Siliziumsolarzellen mit n-Grunddotierung und p-dotierter Vorderseite (J. Zhao, J. Schmidt, A. Wang, G. Zhang, B. S. Richards and M. A. Green, "Performance instability in n-type PERT silicon solar cells", Proceedings of the 3rd World Conference on Photovoltaic Solar Energy Conversion, 2003). Leerläufspannung und Kurzschlussstrom degradieren stark unter Beleuchtung und langer Lagerung im Dunkeln. Als Grund für die Degradation wurde die Anreicherung von positiven Ladungen im Siliziumnitrid und/öder Siliziumoxid auf der Vorderseite identifiziert. Sie führen zur Verarmung der Siliziumoberfläche und somit zu einer Erhöhung der Oberflächenrekombinationsgeschwindigkeit für Minoritätsladungsträger. Charakteristisch ist, dass dadurch der Parallelwiderstand und somit der Füllfaktor nicht beeinträchtigt werden.

Beobachtet wurde die Degradation der Leerlaufspannung und des Kurzschlussstroms aufgrund von Ladungen auf der Vorderseite auch bei beidseitig kontaktierten Siliziumsolarzellen mit n-Grunddotierung, n-dotierter Vorderseite und p-dotierter Rückseite (J. Zhao, aaO). Sie degradieren ebenfalls stark unter Beleuchtung und langer Lagerung im Dunkeln aufgrund von Anreicherung negativer Ladungen im Siliziumnitrid und/oder Siliziumoxid auf der Vorderseite. Die negativen Ladungen führen in diesem Fall zur Verarmung der n-dotierten Siliziumoberfläche und damit wiederum zur Erhöhung der Oberflächenrekombinationsgeschwindigkeit. Charakteristisch ist auch in diesem Fall, dass der Parallelwiderstand und somit der Füllfaktor nicht beeinträchtigt werden.

Für Module, die rückseitig kontaktierte Solarzellen mit n-Grunddotierung, n-dotierter Vorderseite und lokalen p- und n-dotierten Bereichen auf der Rückseite des Substrats enthalten, ist eine Degradation aufgrund von Ladungen bekannt (siehe: R. Swanson, M. Cudzinovic, D. DeCeuster, V. Desai, J. Jürgens, N. Kaminar, W. Mulligan, L. Rodrigues-Barbosa, D. Rose, D. Smith, A. Terao and K. Wilson, "The surface polarization effect in high-efficiency silicon solar cells", Proceedings of the 15th international Photovoltaic Science & Engineering Conference, p. 410, 2005; Hans Oppermann, "Solarzelle", Patentantrag WO 2007/022955 sowie Philippe Welter, "Zu gute Zellen", Photon, S. 102, April 2006). Besitzen diese Module ein hohes positives Potential gegenüber Erde, so wandern negative Ladungen auf die Vorderseite der Solarzellen, an denen keine Kontakte angebracht sind. Dort können sie wegen der geringen elektrischen Leitfähigkeit des Modulverbunds auch nach Abschalten der Systemspannung über lange Zeit verbleiben. Dadurch wird die Oberflächenrekombinationsgeschwindigkeit an der Vorderseite erhöht und somit Leerlaufspannung und Kurzschlussstrom reduziert. Interessanterweise wurde auch eine Reduktion des Füllfaktors berichtet. Es tritt keine Degradation auf, wenn der positive Pol des Systems geerdet wird, d. h. wenn von vornherein nur negative Systemspannungen zugelassen werden. Offensichtlich führen positive Ladungen auf der Vorderseite dieses Solarzelltyps also nicht zu einer Degradation. Wenn eine Degradation aufgrund von negativen Ladungen auf der Vorderseite bereits stattgefunden hat, kann durch Umpolung der Systemspannung im Dunkeln bzw. über Nacht, d. h. durch Anlegen eines hohen negativen Potentials gegenüber Erde, die Degradation vorübergehend rückgängig gemacht werden (Regeneration mittels Kompensationsspannung). Dabei fließen die negativen Ladungen von der Oberfläche der Solarzellen ab. Am nächsten Tag setzt die Degradation aufgrund hoher positiver Systemspannung allerdings wieder ein, so dass die Regeneration jede Nacht erneut durchgeführt werden muss.

Ferner wurde in R. Swanson, aaO, zur Verhinderung der Ansammlung von Ladungen auf der Vorderseite von Solarzellen, bei denen sich alle pn-Übergänge und Metallkontakte auf der Rückseite des Substrats befinden, vorgeschlagen, einen leitenden Überzug auf die Antireflexschicht auf der Vorderseite aufzubringen und diesen Überzug mit dem Plus- oder Minuspol der Solarzellen auf der Rückseite leitend zu verbinden.

Beidseitig kontaktierte Siliziumsolarzellen mit p-Grunddotierung und n-dotierter Vorderseite sind gegenüber den oben beschriebenen Solarzelltypen wesentlich unempfindlicher auf Änderungen der Oberflächenrekombinationsgeschwindigkeit auf der Vorderseite. Deswegen wurde unter Beleuchtung und langer Lagerung im Dunkeln nur eine geringe Degradation der Leerlaufspannung festgestellt (J. Zhao, aaO).

In Ines Rutschmann, "Noch nicht ausgelernt", Photon, S. 122, Januar 2008 und Ines Rutschmann, "Polarisation überwunden", Photon, S. 124, August 2008 wird beschrieben, dass Module mit beidseitig kontaktierten Siliziumsolarzellen mit p-Grunddotierung und n-dotierter Vorderseite nach dem Einwirken hoher negativer Systemspannungen niedrige Parallelwiderstände und somit auch niedrige Füllfaktoren aufweisen. Dies ist ein Zeichen für eine Wechselwirkung zwischen Emitter und Basis und ist somit grundsätzlich verschieden von den oben beschriebenen Auswirkungen auf die Oberflächenrekombinationsgeschwindigkeit. Durch Behandlung bei erhöhter Temperatur und hoher Feuchtigkeit erlangen die degradierten Module ihre Leistungsfähigkeit teilweise zurück. Bei hohen positiven Systemspannungen wurde keine Degradation festgestellt und bereits degradierte Module konnten durch Anlegen eines hohen positiven Potentials gegenüber Erde bei Dunkelheit vorübergehend degeneriert werden, d. h. eine Regeneration mittels Kompensationsspannung ist auch in diesem Fall möglich, aber mit umgekehrter Polung wie bei den oben beschriebenen Modulen, die rückseitig kontaktierte Solarzellen mit n-Grunddotierung, n-dotierter Vorderseite und lokalen p- und n-dotierten Bereichen auf der Rückseite des Substrats enthalten. Bei hohen negativen Systemspannungen setzt die Degradation wieder ein, so dass die Regeneration mittels Kompensationsspannung auch in diesem Fall regelmäßig wiederholt werden muss. Ferner wird berichtet, dass die Degradation der Module bei hohen negativen Systemspannungen durch das verwendete Vorderseitenmetallisierungsverfahren, einem speziellen Transferdruck, verursacht wird (s. Rutschmann, aaO).

Aus der US-A-4,343,962 ist eine Solarzelle bekannt, die aus einem n-dotierten frontseitigen Bereich und einem p-dotierten rückseitigen Bereich, einem Frontseitenköntakt, einem Rückseitenkontakt und zumindest einer ersten frontseitigen Schicht besteht, die aus Siliziumdioxid bestehen und als Antireflexionsschicht dienen kann. Die Schicht kann auch Nitride enthalten.

In der US-A-4,144,094 ist eine Solarzelle mit einer Antireflexions-Frontschicht beschrieben, die aus Störstellen aufweisendem Siliziumnitrid besteht.

Aus der US-B-7,554,031 ist eine Rückseitenkontaktsolarzelle bekannt, die eine n-Grunddotierung aufweist. Um bei aus entsprechenden Solarzellen zusammengesetzten Solarzellenmödulen eine schädliche Polarisation zu verhindern, wird ein Bereich des Solarzellenmoduls vorgespannt.

Der WO-A-2008/072828 ist eine Solarzelle mit p-n-Übergang, einer frontseitigen ersten SiN-Schicht und einer zweiten Schicht aus SiOxNy:Hz zu entnehmen.

In der US-A-2006/196535 wird ein Solarzellenmodul mit einer undotierten Siliciumdioxid-Schicht als Passivierungsschicht zwischen einem frontseitigen n-dotierten Waferbereich und einer Antireflexionsschicht beschrieben.

Aus der WO-A-2007/022955 ist ein Solarzellenmodul bekannt, bei dem eine Einlagerung positiver Ladungsträger in die Antireflexionsschicht und eine damit einhergehende Degradation des Füllfaktors dadurch vermieden wird, indem entweder eine externe Spannung zwischen Solarzelle und Erde über Nacht angelegt wird der indem die Antireflexionsschicht an der Oberfläche transparent leitend beschichtet wird.

Der WO2008/098407 A1 ist eine Solarzelle mit n-basiertem Substrat zu entnehmen, auf dem frontseitig eine Passivierungsschicht, eine n-dotierte Schicht und sodann eine Antireflexionsschicht aufgebracht sind.

Gegenstand der EP 1 304 748 A2 ist die Herstellung einer Solarzelle, bei der zur Oberflächen- bzw. Volumenpassivierung in die Passierungs- bzw. Antireflexionssschicht katalytische Dotierstoffe eingelagert werden.

Die US 2009/0151582 A1 bezieht sich auf eine Solarzelle mit Heteroübergang.

Der vorliegenden Erfindung liegt die Aufgabe zu Grunde, eine kristalline Solarzelle, ein Verfahren zur Herstellung einer solchen sowie ein Verfahren zur Herstellung eines Solarzellenmoduls der eingangs erläuterten Arten so weiterzubilden, dass die Degradation des Parallelwiderstandes und somit des Füllfaktors verringert wird, insbesondere von beidseitig kontaktierten Siliziumsolarzellen mit p-Grunddotierung, n-dotierter Vorderseite und einer Antireflexschicht bestehend aus Siliziumnitrid, aufgrund von hohen negativen Systemspannungen oder positiven Ladungen auf der Vorderseite.

Zur Lösung der Aufgabe sieht die Erfindung im Wesentlichen eine kristalline Solarzelle vor, die sich dadurch auszeichnet, dass zwischen der ersten Schicht und dem n-dotierten Bereich eine zweite Schicht aus zumindest einem Material aus der Gruppe SiN, SiOₓ, Al₂Oₓ, SiOₓN_{y}: Hz, a-Si:H, TiOₓ oder ein solches Material enthaltend angeordnet und zur Bildung von Störstellen dotiert ist.

Die aus SiN bestehende oder SiN enthaltende zweite Schicht sollte ein Silizium-Stickstoff-Verhältnis von 1 bis 2,2 und eine H-Atomkonzentration von über 10 % enthalten.

Um eine noch verbesserte Stabilität zu erzielen, ist vorgesehen, dass in der ersten Schicht positive und/oder negative Ladungsträger nach Herstellung der ersten Schicht eingelagert werden.

Vorzugsweise beträgt die Flächenladungsdichte der Ladungsträger > 1·10¹²/cm².

Insbesondere sollte nach Herstellung der Solarzelle an diese eine negative Spannung Uₙ über eine vorgegebene Zeit angelegt werden.

Auch zeichnet sich die Erfindung dadurch aus, dass nach Herstellung der Solarzelle auf diese positive Ladungen aufgebracht werden.

Sofern die zweite Schicht aus SiN besteht oder SiN enthält, sollte diese einen Brechungsindex n mit n ≥ 2, insbesondere zwischen 2,1 und 3,0 aufweisen.

Vorzugsweise sollte die zweite Schicht mit einer Dicke D₂ mit 1 nm ≤ D₂ ≤ 50 nm ausgebildet werden.

Überraschenderweise hat sich gezeigt, dass dann, wenn in die frontseitige Siliziumnitridschicht oder eine zwischen dieser und dem n-dotierten Bereich der Solarzelle vorhandene Siliziumnitridschicht Störstellen eingebracht werden, die Degradation des Parallelwiderstandes stark verhindert bzw. zumindest stark verringert wird. Die Störstellen werden insbesondere durch Dotierung mit einem Element aus der Gruppe P, N, Sb, Bi, C, O, B, Al, Ga, In, Tl, Cu, V, W, Fe, Cr erzeugt.

Anstelle der Siliziumnitridschicht kann auch eine Schicht aus einem anderen Material, vorzugsweise SiOₓ, Al₂Oₓ, SiOₓN_{y}:H_{z}, a-Si, a-Si:H oder TiOₓ vorgesehen sein.

In der zweiten Schicht können Störstellen durch Dotierung mit zumindest einem Element aus der Gruppe P, N, Sb, Bi, C, O, B, Al, Ga, In, Tl, Cu, V, W, Fe, Cr erzeugt werden.

In einer Ausführungsform besteht die Schicht aus SiOₓ, das mittels UV-Beleuchtung des Siliziumsubstrats mit Wellenlängen λ < 400 nm in sauerstoffhaltiger Atmosphäre erzeugt wurde. In einer anderen Ausführungsform besteht die Schicht aus SiOₓ, das bei Temperaturen im Bereich zwischen 300 und 1000°C in sauerstoffhaltiger Atmosphäre erzeugt wurde.

Durch die zusätzliche Schicht wird die Ausbildung von niedrigen Parallelwiderständen bei hohen negativen Systemspannungen oder nach dem Aufbringen positiver Ladungen auf die Vorderseite der Solarzellen im Vergleich zu anderen Solarzellen, bei denen die Siliziumnitridschicht direkt auf die n-dotierte Vorderseite abgeschieden wurde, stark verringert.

Des Weiteren zeichnet sich die Erfindung durch ein Verfahren zur Herstellung einer kristallinen Solarzelle mit frontseitigem n-dotierten Bereich, rückseitigem p-dotieren Bereich, Front- und Rückseitenkontakten sowie zumindest einer frontseitigen Schicht aus SiN oder SiN enthaltend als erste Schicht wie Antireflexionsschicht dadurch aus, dass zwischen der ersten Schicht und dem n-dotierten Bereich eine als zweite Schicht angeordnet wird, die aus zumindest einem der Materialien aus der Gruppe SiN, SiOₓ, Al₂Oₓ, SiOₓN_{y}:Hz, a-Si:H, TiOₓ besteht oder dieses enthält, dass nach Herstellung der Solarzelle entweder an die Solarzelle eine negative Spannung Uₙ angelegt wird oder in die erste Schicht positive und/oder negative Ladungsträger eingebracht werden. Ferner sollte die zweite Schicht zur Bildung von Störstellen mit vorzugsweise ein Element aus der Gruppe P, N, Sb, Bi, C, O, B, Al, Ga, In, Tl, Cu, V, W, Fe, Cr dotiert sein.

Somit sieht eine weitere Lösung der Aufgabe vor, dass die Solarzelle - wie oben beschrieben - mit einer zusätzlichen Schicht zwischen Siliziumsubstrat und Siliziumnitridschicht ausgestattet wird und zusätzlich positive Ladungen auf die Solarzelle aufgebracht werden. Dabei befindet sich die Solarzelle vorteilhafterweise bei Temperaturen im Bereich von 10°C bis 600°C.

Eine Lösung der Aufgabe sieht ferner vor, dass die Solarzelle - wie oben beschirieben - mit einer zusätzlichen Schicht zwischen Siliziumsubstrat und Siliziumnitridschicht ausgestattet wird und nach Einlamination in ein Modul der Solarzellverbund vorübergehend gegenüber Erde mit hoher negativer Spannung beaufschlagt wird. Dabei sollte sich das Modul bei Temperaturen im Bereich von 10 °C bis 220 °C befinden.

Überraschenderweise wurde gefunden, dass mit fortschreitendem Aufbringen positiver Ladungen auf die Solarzelle bzw. mit fortschreitendem Anlegen hoher negativer Spannung an das Modul gegenüber Erde der Parallelwiderstand der Solarzelle bzw. des Solarmoduls zunächst abnimmt, dann jedoch wieder nahezu auf den Ausgangswert ansteigt und somit die Degradation praktisch vollständig rückgängig gemacht wird. Auf diesem hohen Wert verbleibt der Parallelwiderstand dauerhaft, auch wenn keine zusätzlichen positiven Ladungen mehr auf die Solarzelle aufgebracht werden bzw. keine negative Spannung mehr an dem Solarzellverbund im Modul gegenüber Erde anliegt. Hohe Temperaturen beschleunigen diesen Prozess der dauerhaften Regeneration.

Insbesondere sollte bei einer Temperatur zwischen 50° C und 200° C, bevorzugt 80° C, eine negative Spannung an die Solarzelle angelegt und/oder in die erste Schicht positive und/oder negative Ladungen eingebracht werden.

Das erfindungsgemäße Verfahren unterscheidet sich grundlegend von der vorübergehenden Regeneration, die für Solarzellen ohne zusätzliche Schicht zwischen Siliziumsubstrat und Siliziumnitridschicht bekannt ist und beim Anlegen einer positiven Spannung beobachtet wurde.

Ein weiterer Lösungsvorschlag der der Erfindung zu Grunde liegenden Aufgabe sieht vor, dass auf die beidseitig kontaktierten Siliziumsolarzellen mit p-Grunddotierung, n-dotierter Vorderseite und einer Antireflexschicht bestehend aus Siliziumnitrid ein optisch transparenter leitfähiger Überzug auf die Vorderseite aufgebracht wird. Dadurch werden Antireflexschicht und die Vorderseiten-Metallkontakte ohne weitere zusätzliche Maßnahmen leitend miteinander verbunden. Weil Vorderseiten-Metallkontakte wiederum elektrisch leitend mit der n-dotierten Vorderseite verbunden sind, bleibt die Antireflexschicht auch bei hohen Systemspannungen frei von elektrischen Feldern und es werden somit keine Ladungen in die Antireflexschicht eingebracht.

Ein Verfahren zur Herstellung eines Solarzellenmoduls der eingangs genannten Art zeichnet sich dadurch aus, dass der Rahmen gegenüber zumindest einem Anschluss des Solarzellenmoduls mit einer hohen positiven elektrischen Spannung über eine vorgegebene Zeit beaufschlagt wird. Dabei ist insbesondere vorgesehen, dass zwischen dem Rahmen und dem zumindest einen elektrischen Kontakt eine positive elektrische Spannung zwischen 100 V und 20.000 V angelegt wird, wobei vorzugsweise die positive elektrische Spannung über eine Zeit t₁ mit 0,5 sec ≤ t₁ ≤ 1200 min angelegt wird.

Eine alternative Lösung zur Herstellung eines Solarzellenmoduls sieht vor, dass auf das Solarzellenmodul über eine Zeit t₂ eine elektrisch leitende Flüssigkeit, eine elektrisch leitende Kunststöfffolie oder eine elektrisch leitende Metallfolie aufgebracht und an dieser gegenüber zumindest einem der elektrischen Kontakte des Solarzellenmoduls über eine vorgegebene Zeit t₃ eine hohe positive elektrische Spannung angelegt wird. Dabei sollte zwischen der leitenden Flüssigkeit bzw. der Kunststofffolie bzw. der Metallfolie und dem zumindest einen elektrischen Kontakt eine positive elektrischen Spannung zwischen 100 V und 20.000 V angelegt werden.

Insbesondere ist vorgesehen, dass die Flüssigkeit bzw. Kunststofffolie bzw. Metallfolie über eine Zeit t₂ mit 0,5 sec ≤ t₂ ≤ 1200 min auf dem Solarzellenmodul angeordnet wird bzw. die positive elektrischen Spannung über eine Zeit t₃ mit 0,5 sec ≤ t₃ ≤ 1200 min angelegt wird.

Des Weiteren bezieht sich ein gattungsgemäßes Beispiel auf ein Solarzellenmodul umfassend vershal tete kristalline p- oder n-Solarzellen, die jeweils einen frontseitigen n- oder p-dotieren Bereich, einen rückseitigen p- oder n-dotierten Bereich, einen Frontseitenkontakt, einen Rückseitenkontakt, zumindest eine frontseitige Schicht aus SiN oder SiN enthaltend, wobei die Solarzellen frontseitig von einem optisch transparenten Einbettmaterial aus Kunststoff abgedeckt sind, über dem Einbettmaterial eine elektrisch isolierende, optisch transparente Abdeckung aus Glas oder Kunststoff angeordnet ist, die Solarzellen rückseitig von einem Einbetmaterial aus Kunststoff abgedeckt sind und so gebildete Einheit von einem umlaufenden metallischen Rahmen umgeben ist, und zeichnet sich dadurch aus, dass zwischen dem frontseitigen Kunststoffeinbettmaterial und der Abdeckung eine elektrisch leitende sowie optisch zumindest teiltransparente Schicht angeordnet wird, die elektrisch leitend mit einem der elektrischen Kontakte des Solarzellenmoduls verbunden wird.

Aufgrund der erfindungsgemäßen Lehren wird die Degradation des Parallelwiderstands zu dem pn-Übergang zumindest reduziert bzw. dauerhaft vermieden, so dass der Wirkungsgrad der Solarzellen und damit des Solarzellenmoduls nicht unzulässig verringert wird. Dabei wird nach einem Lösungsvorschlag zur dauerhaften Regeneration eines zunächst reduzierten Parallelwiderstands eine Gleichspannung zwischen zumindest einem Anschluss der Solarzelle bzw. des Solarzellenmoduls und Erde angelegt, und zwar bei p-dotierten kristallinen Siliziumsolarzellen mit p-dotierten Substrat und n-dotieiter Frontseite eine negative Spannung, sofern eine Zwischenschicht eingebaut wird, die nicht aus Siliziumnitrid besteht, sondern eine solche, die bevorzugterweise aus zumindest einem Material aus der Gruppe SiOₓ, Al₂Oₓ, SiOₓN_{y}:Hz, a-Si:H, TiOₓ besteht.

Eine Störstellen aufweisendes Siliziumnitridschicht- sei es eine Zwischenschicht, sei es die frontseitige Siliziumnitridschicht wie Antireflexschicht - bedarf einer diesbezüglichen Spannungsanlegung nicht.

Anstelle der Spannungsanlegung kann auch ein Einbringen von insbesondere negativen Ladungsträgern in die frontseitige Siliziumnitridschicht erfolgen, die die gleiche Wirkung herbeiführen. Damit die negativen Ladungsträger eingebracht werden können, werden auf die Oberseite der Solarzelle vorzugsweise mittels Koronaentladung positive Ladungen aufgebracht. Auch in diesem Fall tritt nach anfänglicher Reduktion des Parallelwiderstandes eine dauerhafte Regeneration ein.

Das Einbringen der Ladungsträger in die Siliziumnitridschicht erfolgt dadurch, dass durch das Aufbringen der positiven Ladungsträger aus dem Siliziumnitrid negative Ladungsträger in die Siliziumnitridschicht gelangen und dort verbleiben, so dass anschließend die positiven Ladungen von der Oberseite der Solarzelle entfernt werden können.

Ein Einbringen von Ladungsträgern bzw. ein Anlegen einer hohen Spannung ist auch dann nicht erforderlich, wenn die Solarzellen an ihrer Oberseite oder die Solarzellenmoduls vorzugsweise über die die einzelnen Solarzellen einbettende Isolationsschicht wie EVA mit einer elektrisch leitenden, optisch zumindest teiltransparenten Schicht abgedeckt sind, die sodann bei unmittelbarem Auftragen auf die Solarzelle mit dem vorzugsweise streifen- oder punktförmigen Frontkontakt oder bei Aufbringen auf die Isolationsschicht wahlweise mit dem Front- oder Rückkontakt verbunden wird.

Daher zeichnet sich die Erfindung nach einem selbständigen Lösungsvorschlag auch durch eine kristalline Solarzelle mit einem fronstseitig n-dotierten Bereich, einem rückseitigen p-dotierten Bereich, einem Frontseitenkontakt, einem Rückseitenkontakt und zumindest einer frontseitigen ersten Schicht aus SiN oder SiN enthaltend wie Antireflexionsschicht dadurch aus, dass auf der ersten Schicht oder einer über dieser verlaufenden Isolationsschicht eine elektrisch leitende und optisch zumindest teiltransparente dritte Schicht angeordnet ist, die bei einer Anordnung auf der ersten Schicht mit dem Frontkontakt und bei einer Anordnung auf der Isolationsschicht mit dem Front- oder Rückkontakt elektrisch leitend verbunden ist.

Weitere Einzelheiten, Vorteile und Merkmale der Erfindung ergeben sich nicht nur aus den Ansprüchen, den diesen u entnehmenden Merkmalen - für sich und/oder in Kombination -, sondern auch aus der nachfolgenden Beschreibung der bevorzugten Ausführungsbeispiele und den Zeichnungen.

Es zeigen:
- Fig. 1: eine erste Ausführungsform der Siliziumsolarzelle mit verbesserter Stabilität bei hohen negativen Systemspannungen,
- Fig. 2: gemessenen Parallelwiderstand einer Siliziumsolarzelle mit verbesserter Stabilität bei hohen negativen Systemspannungen als Funktion der Beladungszeit mit positiven Landungen,
- Fig. 3: eine weitere Ausführungsform der Siliziumsolarzelle mit verbesserter Stabilität bei hohen negativen Systemspannungen und
- Fig. 4: eine Ausführungsform eines Solarmoduls mit verbesserter Stabilität bei hohen Systemspannungen.

Bei der nachfolgenden Beschreibung von bevorzugten Ausführungsbeispielen wird unterstellt, dass der Aufbau und die Funktion einer Solarzelle bzw. eines Solarzellenmoduls hinlänglich bekannt sind, insbesondere in Bezug auf p-grunddotierte kristalline Siliziumsolarzellen und aus diesen hergestellten Module.

Des Weiteren ist anzumerken, dass die Erfindung auch Solarzellen einschließt, die frontseitig mehrere Siliziumnitridschichten aufweisen, wie dies nach dem Stand der Technik bekannt ist. Insoweit ist der Begriff frontseitige Siliziumnitridschicht als Synonym für ein oder mehrere frontseitige Siliziumnitridschichten zu verstehen. Ferner sind die angegebenen Dimensionierungen grundsätzlich rein beispielhaft zu verstehen, ohne dass hierdurch die erfindungsgemäße Lehre eingeschränkt wird.

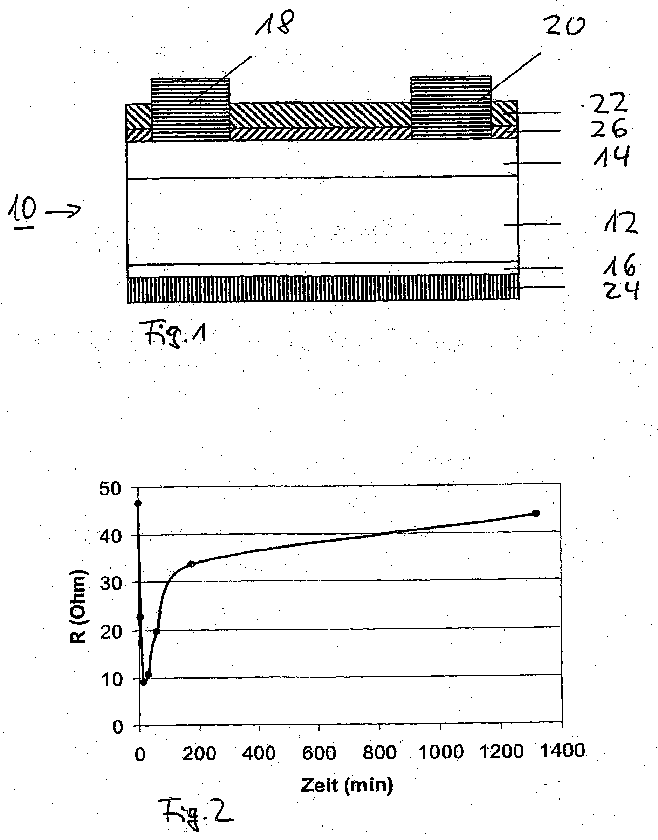

In Fig. 1 ist rein prinzipiell eine kristalline Siliziumsolarzelle 10 dargestellt. Diese weist ein p-grunddotiertes Substrat 12 in Form z. B. einer 180 µm dicken Siliziumscheibe auf, die auf der Vorderseite, also frontseitige ganzflächig n⁺ dotiert ist. Der entsprechende Bereich ist mit 14 gekennzeichnet. Rückseitig ist das Substrat 12 p⁺-diffundiert (Bereich bzw. Schicht 16). Frontseitig finden sich des Weiteren streifenförmige oder punktuelle Frontköntakte 18, 20. Die Frontseite der Solarzelle weist eine aus Siliziumnitrid bestehende Antireflexionsschicht 22 auf, die z. B. einen Brechungsindex von 1,9 aufweisen kann. Auf der Rückseite ist ein ganzflächiger Rückkontakt 24 angeordnet.

Erfindungsgemäß ist nach einer Ausführungsform zwischen der frontseitigen oder ersten Siliziumnitridschicht 22 und dem n⁺-diffundierten Bereich 14 eine weitere als zweite Schicht zu bezeichnende Siliziumnitridschicht 26 angeordnet, die einen Brechungsindex von z. B. 2,3 und eine Dicke von 25 nm aufweist.

Durch das Aufbringen der Zwischenschicht, also zweiten Schicht 26 zwischen der Antireflexionsschicht 22 und dem n⁺-Bereich 14 wird erreicht, dass eine Degradation des Parallelwiderstands zu dem pn-Übergang, der zwischen den Schichten 12, 14 besteht, vermieden bzw. stark verringert wird. Die Zwischenschicht 26 weist durch Dotierungen Störstellen bzw. -bereiche auf. Als Dotierungen kommt bevorzugterweise ein Element aus der Gruppe P, N, Sb, Bi, C, O, B, Al, Ga, In, Tl, Cu, V, W, Fe, Cr Frage.

Eine Degradation des Parallelwiderstandes muss vermieden werden, da dann, wenn dieser zu stark abnimmt, quasi ein Kurzschluss im pn-Übergang auftritt, so dass die Solarzelle nicht mehr ordnungsgemäß arbeiten kann.

Anstelle der aus Siliziumnitrid bestehenden Zwischenschicht 26 kann zur Vermeidung der Degradation des Parallelwiderstandes in Folge von hohen Systemspannungen und der Ladung auf der Vorderseite der Solarzelle bzw. eines aus entsprechenden Solarzellen bestehenden Moduls eine Schicht aus einem anderen Material wie SiOₓ, Al₂Oₓ, Si-OₓN_{y}:Hz, a-Si:H und/oder TiOₓ eingefügt werden. In diesem Fall wird nach der Herstellung der Solarzelle bzw. dem Verschalten entsprechender Solarzellen zu einem Modul an einem der Kontakte der Solarzelle bzw. des Solarzellenmoduls, also an den Plus- oder Minus-Pol oder an beiden Kontakten eine hohe negative Gleichspannung gegenüber Erde angelegt. Als Dotierung für die Schicht kommt insbesondere ein Element aus der Gruppe P, N, Sb, Bi, C, O, B, Al, Ga, In, Tl, Cu, V, W, Fe, Cr in Frage.

Alternativ können auf die Solarzelle, und zwar auf deren Vorderseite, positive Ladungen z. B. mittels einer Koronaentladung aufgebracht werden. Hierdurch werden in die entsprechende Zwischenschicht insbesondere negative Ladungen eingebracht, die aus der n⁺-Schicht stammen, wodurch gleichfalls eine entsprechende Degradation verhindert bzw. reduziert wird. Dies soll anhand der Fig. 2 verdeutlicht werden. So zeigt die Fig. 2 den zeitlichen Verlauf des Parallelwiderstands zum pn-Übergang einer erfindungsgemäßen Solarzelle, bei der entsprechend der erfindungsgemäßen Lehre zwischen der frontseitigen Siliziumnitridschicht 22, die erwähntermaßen aus mehreren Schichten bestehen kann, und dem n⁺-Bereich 14, der auch als Schicht bezeichnet werden kann, eine Zwischenschicht aus SiOₓ angeordnet wird. Die Messungen erfolgen dabei bei einer kristallinen Siliziumsolarzelle, bei der der Brechungsindex oder Siliziumnitridschicht 22 n = 2,1 bei einer Dicke der Schicht von 80 nm betrug. Die Zwischenschicht wies eine Dicke von ca. 2 nm auf und wurde aus der n⁺-Schicht mittels UV-Licht mit einer Wellenlänge < 300 nm erzeugt. Anschließend wurde auf der Vorderseite der entsprechenden Solarzelle durch Koronaentladung positive Ladung aufgebracht. Es wurde der Parallelwiderstand entsprechend der Fig. 2 gemessen. Man erkennt, dass nach anfänglicher Reduktion des Parallelwiderstandes nach ca. 15 min eine dauerhafte Regeneration eintritt.

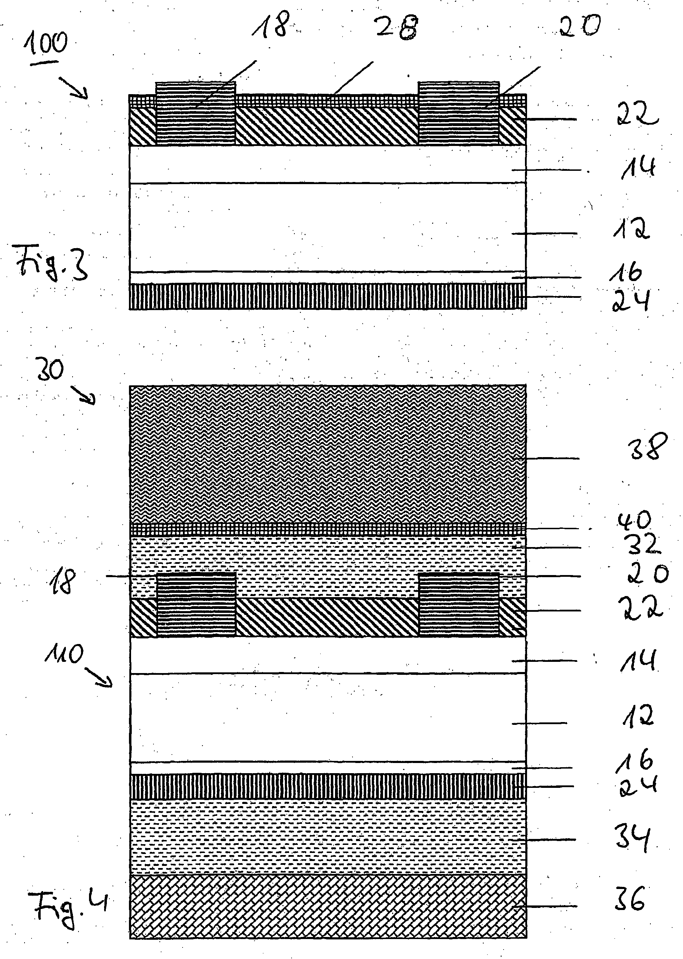

Eine weitere Ausführungsform einer Solarzelle 100 ist der Fig. 3 zu entnehmen. Anstelle der Zwischenschicht 26 ist auf die frontseitige Siliziumnitridschicht 22 eine optisch transparente elektrisch leitfähige Schicht 28 aufgebracht, die aus Indium-Zinn-Oxid oder Zink-Oxid bestehen kann. Die Schicht 28 überdeckt dabei die Antireflexionsschicht 22 und kann sich auch über die Frontkontakte 18, 20 erstrecken. Im Ausführungsbeispiel werden die Frontkontakte 18, 20 frei gelassen. Unabhängig hiervon ist eine elektrisch leitende Verbindung zwischen der Schicht 28 und den Frontkontakten 18, 20 gegeben. Durch die diesbezüglichen Maßnahmen ist gleichfalls eine Degradation des Parallelwiderstandes vermeidbar bzw. stark reduzierbar.

Erfindungsgemäße Solarzellen zuvor erläuterter Art werden zu Solarzellenmodulen verschaltet, um eine verbesserte Stabilität dieser bei hohen Systemspannungen zu erzielen. In Fig. 4 ist ein Ausschnitt eines entsprechenden Moduls 30 mit einer Solarzelle 10 dargestellt.

In bekannter Weise werden die Solarzellen 110 vorder- und rückseitig von einer transparenten Kunststoffschicht aus z. B. Ethylenvinylacetat (EVA) umgeben und in diese eingebettet. Die entsprechenden Schichten sind mit den Bezugszeichen 32, 34 gekennzeichnet. Ferner erstreckt sich rückseitig entlang der EVA-Schicht 34 eine Rückseitenfolie 36, die z. B. aus Polyvinylfluorid (TEDLAR) bestehen kann. Frontseitig wird die EVA-Schicht 32 von einer Glasplatte 38 abgedeckt. Die so gebildete Einheit wird von einem Rahmen aus Metall umgeben, der auf Masse liegt.

Zwischen der frontseitigen EVA-Schicht 32 und der Glasscheibe 38 ist eine transparente elektrisch leitfähige Schicht 40 angeordnet, die aus Indium-Zinn-Oxid oder Zink-Oxid bestehen kann. Die entsprechende Schicht 40 ist sodann mit einem der Pole des Moduls, also mit dem Plus- oder Minus-Pol verbunden. Eine diesbezügliche Anordnung bietet gleichfalls die Vorteile, wie diese auch im Zusammenhang mit der Fig. 3 erläutert worden sind.

Anstelle der Solarzelle 110 können auch Solarzellen 10, 100 oder solche zu einem Modul verschaltet werden, die entsprechend zuvor erfolgter Erläuterungen der erfindungsgemäßen Lehre folgen.

## Patentansprüche

1. Kristalline Solarzelle (10, 100, 110) mit einem p-grunddotierten Substrat (12), einem frontseitigen n-dotierten Bereich (14) und einem rückseitigen p-dotierten Bereich (16), einem Frontseitenkontakt, (18, 20) einem Rückseitenkontakt (24) und zumindest einer frontseitigen ersten Schicht (22) aus SiN oder SiN enthaltend wie Antireflexionsschicht,
**dadurch gekennzeichnet,**
**dass** zwischen der ersten Schicht (22) und dem n-dotierten Bereich (14) eine zweite Schicht (26) aus zumindest einem Material aus der Gruppe SiN, SiOₓ, Al₂Oₓ, SiOₓN_{y}: H_{z}, a-Si:H, TiOₓ oder ein solches Material enthaltend angeordnet und zur Bildung von Störstellen dotiert ist.

2. Solarzelle nach Anspruch 1,
**dadurch gekennzeichnet,**
**dass** die aus SiN bestehende oder SiN enthaltende zweite Schicht (26) einen Brechungsindex n mit n ≥ 2, insbesondere mit 2,1 ≤ n ≤ 3,0 aufweist.

3. Solarzelle nach Anspruch 1,
**dadurch gekennzeichnet,**
**dass** die aus SiN bestehende oder SiN enthaltende zweite Schicht ein Silizium-Stickstoff-Verhältnis von 1 bis 2,2 und eine H-Atomkonzentration von über 10 % enthält.

4. Solarzelle nach zumindest Anspruch 1,
**dadurch gekennzeichnet,**
**dass** in der ersten Schicht (22) positive und/oder negative Ladungsträger nach Herstellung der ersten Schicht eingelagert sind.

5. Solarzelle nach zumindest Anspruch 4,
**dadurch gekennzeichnet,**
**dass** Flächenladungsdichte der Ladungsträger > 1 · 10¹²/cm² beträgt.

6. Solarzelle nach Anspruch 1,
**dadurch gekennzeichnet,**
**dass** auf der ersten Schicht (22) oder einer über dieser verlaufenden Isolationsschicht eine elektrisch leitende und optisch zumindest teiltransparente dritte Schicht (28) angeordnet ist, die bei einer Anordnung auf der ersten Schicht mit dem Frontkontakt (18, 20) und bei einer Anordnung auf der Isolationsschicht mit dem Front- oder Rückkontakt elektrisch leitend verbunden ist.

7. Solarzelle nach zumindest einem der vorhergehenden Ansprüche,
**dadurch gekennzeichnet,**
**dass** die zweite Schicht (26) eine Dicke D₂ mit 1 nm ≤ D₂ ≤ 50 nm aufweist.

8. Solarzelle nach zumindest einem der vorhergehenden Ansprüche,
**dadurch gekennzeichnet,**
**dass** die zweite Schicht insbesondere eine SiOₓ-Schicht ist, die aus dem n-dotierten Bereich ausgebildet ist.

9. Solarzelle nach zumindest einem der vorhergehenden Ansprüche,
**dadurch gekennzeichnet,**
**dass** die zweite Schicht (26) mit zumindest einem Element aus der Gruppe P, N, Sb, Bi, C, O, B, Al, Ga, In, Tl, Cu, V, W, Fe, Cr dotiert ist.

10. Solarzelle nach zumindest einem der vorhergehenden Ansprüche,
**dadurch gekennzeichnet,**
**dass** die dritte Schicht (28) aus Indium-Zinn-Oxid oder Zink-Oxid besteht oder dieses enthält.

11. Solarzelle nach zumindest einem der vorhergehenden Ansprüche,
**dadurch gekennzeichnet,**
**dass** bei Ausbilden der zweiten Schicht (26) aus einem anderen Material als SiN die erste Schicht einen Brechungsindex n ≥ 2,0 aufweist oder dass bei Ausbilden der zweiten Schicht aus SiN oder SiN enthaltend der Brechungsindex der ersten Schicht kleiner als der der zweiten Schicht ist.

12. Solarzelle nach zumindest einem der vorhergehenden Ansprüche,
**dadurch gekennzeichnet,**
**dass** die Solarzelle (10, 100, 110) ein negative Systemspannung aufweist.

13. Verfahren zur Herstellung einer kristallinen Solarzelle (10, 100, 110) mit p-grunddotiertem Substrat (12), einem frontseitigen n-dotierten Bereich (14), rückseitigem p-dotierten Bereich (16), Front- und Rückseitenkontakten (18, 20, 24) sowie zumindest einer frontseitigen Schicht (22) aus SiN oder SiN enthaltend als erste Schicht wie Antireflexionsschicht,
**dadurch gekennzeichnet,**
**dass** zwischen der ersten Schicht (22) und dem n-dotierten Bereich (14) eine zweite Schicht (26) angeordnet wird, die aus zumindest einem der Materialien aus der Gruppe SiOₓ, Al₂Oₓ, SiOₓN_{y}:H_{z}, a-Si:H, TiOₓ besteht oder dieses enthält und zur Bildung von Störstellen dotiert ist, dass nach Herstellung der Solarzelle (10, 100, 110) entweder an die Solarzelle eine negative Spannung Uₙ angelegt wird oder in die erste Schicht positive und/oder negative Ladungsträger eingebracht werden.

14. Verfahren nach Anspruch 13,
**dadurch gekennzeichnet,**
**dass** die zweite Schicht (26) mit zumindest einem Element aus der Gruppe P, N, Sb, Bi, C, O, B, Al, Ga, In, Tl, Cu, V, W, Fe, Cr dotiert wird.

15. Verfahren nach Anspruch 13,
**dadurch gekennzeichnet,**
**dass** die Ladungsträger in die erste Schicht (22) bei einer Temperatur T₂ mit 10 °C ≤ T₂ ≤ 600 °C durch Aufbringen positiver Ladungen auf die Vorderseite der Solarzelle (10, 100, 110) eingebracht werden, wobei insbesondere die positiven Ladungen auf die Vorderseite der Solarzelle durch Korona-Entladung aufgebracht werden.

16. Verfahren nach Anspruch 13 oder 15,
**dadurch gekennzeichnet,**
**dass** bei einer Temperatur zwischen 50° C und 200° C, bevorzugt 80° C, eine negative Spannung an die Solarzelle (10, 100, 110) angelegt und/oder in die erste Schicht (22) positive und/oder negative Ladungen eingebracht werden.

17. Verfahren nach zumindest Anspruch 13,
**dadurch gekennzeichnet,**
**dass** aus dem n-dotierten Bereich (14) in sauerstoffhaltiger Atmosphäre bei einer Temperatur T mit 150 °C ≤ T ≤ 1000 °C und insbesondere bei einem Druck zwischen 10⁻⁵ bar und 0,5 bar eine SiOₓ-Schicht als die zweite Schicht (26) ausgebildet wird.

18. Verfahren nach zumindest Anspruch 13,
**dadurch gekennzeichnet,**
**dass** die zweite Schicht (26) in Form einer SiOₓ-Schicht aus dem n-dotierten Bereich (14) in einer ozonhaltigen Atmosphäre oder durch Anwendung ozonhaltiger Flüssigkeit ausgebildet wird.

19. Verfahren nach zumindest Anspruch 13,
**dadurch gekennzeichnet,**
**dass** die zweite Schicht (12), insbesondere die SiOₓ-Schicht, mit einer Dicke D₂ mit 1 nm ≤ D₂ ≤ 50 nm ausgebildet wird, wobei vorzugsweise die zweite Schicht in Form der SiOₓ-Schicht aus dem n-dotierten Bereich (14) in sauerstoffhaltiger Atmosphäre mittels UV-Licht einer Wellenläange λ mit λ < 400 nm ausgebildet wird.

## Claims

1. A crystalline solar cell (10, 100, 110) with a p-basic doped substrate (12), a front-side n-doped area (14), a back-side p-doped area (16), a front-side contact (18, 20), a back-side contact (24), and at least one front-side first layer (22) made of SiN or containing SiN as an anti-reflection layer,
**characterized in that**
between the first layer (22) and the n-doped area (14), a second layer (26) made of at least one material from the group SiN, SiOₓ, Al₂Oₓ, SiOₓN_{y}:H_{z}, a-Si:H, TiOₓ, or containing such a material is arranged and is doped for the creation of imperfections.

2. The solar cell according to claim 1,
**characterized in that**
the second layer (26) composed of SiN or containing SiN has a refractive index n of n ≥ 2, in particular 2.1 ≤ n ≤ 3.0.

3. The solar cell according to claim 1,
**characterized in that**
the second layer composed of SiN or containing SiN contains a silicon-nitrogen ratio of 1 to 2.2 and an H-atom concentration of greater than 10%.

4. The solar cell according to at least claim 1,
**characterized in that**
that positive and/or negative charge carriers are incorporated into the first layer (22) after producing the first layer.

5. The solar cell according to at least claim 4,
**characterized in that**
the charge density of the charge carriers per unit area is > 1 × 10¹²/cm².

6. The solar cell according to claim 1,
**characterized in that**
an electrically conducting and at least partially optically transparent third layer (28) is disposed on the first layer (22) or on an insulation layer extending over it, said third layer being connected in an electrically conductive manner to the front contact (18, 20) for an arrangement on the first layer and to the front or back contact for an arrangement on the insulation layer.

7. The solar cell according to at least one of the preceding claims,
**characterized in that**
the second layer (26) has a thickness D₂ of 1 nm ≤ D₂ ≤ 50 nm.

8. The solar cell according to at least one of the preceding claims,
**characterized in that**
in particular the second layer is an SiOₓ layer that is formed from the n-doped area.

9. The solar cell according to at least one of the preceding claims,
**characterized in that**
the second layer (26) is doped with at least one element from the group P, N, Sb, Bi, C, O, B, Al, Ga, In, Tl, Cu, V, W, Fe, Cr.

10. The solar cell according to at least one of the preceding claims,
**characterized in that**
the third layer (28) is composed of or contains indium tin oxide or zinc oxide.

11. The solar cell according to at least one of the preceding claims,
**characterized in that**
in the case of formation of the second layer from a material other than SiN, the first layer has a refractive index of n ≥ 2.0, or in the case of formation of the second layer (26) from SiN or when it contains SiN, the refractive index of the first layer is smaller than that of the second layer.

12. The solar cell according to at least one of the preceding claims,
**characterized in that**
the solar cell (10, 100, 110) has a negative system voltage.

13. A method for producing a crystalline solar (10, 100, 110) cell with a p-basic doped substrate (12), a front-side n-doped area (14), a back-side p-doped area (16), a front-side contact (18), a back-side contact (20), and at least one front-side first layer (22) made of SiN or containing SiN, as an anti-reflection layer,
**characterized in that**,
between the first layer (22) and the n-doped area (14), a second layer made of at least one material from the group SiOₓ, Al₂Oₓ, SiOₓN_{y}:H_{z}, a-Si:H, TiOₓ, or containing such a material is disposed and is doped for the creation of imperfections, that, after producing the solar cell (10, 100, 110), either a negative voltage Uₙ is applied to the solar cell or else positive and/or negative charge carriers are introduced into the first layer.

14. The method according to claim 13,
**characterized in that**
the second layer (26) is doped with at least one element from the group P, N, Sb, Bi, C, O, B, Al, Ga, In, Tl, Cu, V, W, Fe, Cr.

15. The method according to claim 13,
**characterized in that**
the charge carriers are introduced into the first layer (22) by deposition of positive charges on the front side of the solar cell (10, 100, 110) at a temperature T₂ with 10 °C ≤ T₂ ≤ 600 °C, wherein in particular the positive charges are deposited on the front side of the solar cell by corona discharge.

16. The method according to claim 13 or 15,
**characterized in that**
a negative voltage is applied to the solar cell and/or positive and/or negative charges are introduced into the first layer at a temperature of between 50°C and 200°C, preferably 80°C.

17. The method according to at least claim 13,
**characterized in that**
an SiOₓ layer is formed as the second layer (26) from the n-doped area in an oxygen-containing atmosphere at a temperature T of 150°C ≤ T ≤ 1000°C, and in particular at a pressure of between 10⁻⁵ and 0.5 bar.

18. The method according to at least claim 13,
**characterized in that**
the second layer (26) is formed in the form of an SiOₓ layer from the n-doped area in an ozone-containing atmosphere or by use of an ozone-containing liquid.

19. The method according to at least claim 13,
**characterized in that**
the second layer (12), in particular the SiOₓ layer, is formed with a thickness D₂ of 1 nm ≤ D₂ ≤ 50 nm, wherein in particular the second layer in the form of the SiOₓ layer is formed from the n-doped area (14) in an oxygen-containing atmosphere by means of UV light with a wavelength λ of λ < 400 nm.

## Revendications

1. Cellule solaire cristalline (10, 100, 110) avec un substrat (12) à dopage de base p, une zone avant (14) dopée n et une zone arrière (16) dopée p, un contact avant (18, 20), un contact arrière (24) et au moins une première couche frontale (22), telle qu'un couche antireflet, constituée de SiN ou contenant du SiN,
**caractérisée en ce**
**qu'**entre la première couche (22) et la zone dopée n (14) est placée une deuxième couche (26) qui est constituée d'au moins un matériau du groupe SiN, SiOₓ, Al₂Oₓ, SiOₓN_{y}:H_{z}, a-Si:H, TiOₓ ou contenant un tel matériau, et qui est dopée pour former des défauts.

2. Cellule solaire selon la revendication 1,
**caractérisée en ce**
**que** la deuxième couche (26) constituée de SiN ou contenant du SiN présente un indice de réfraction n tel que n ≥ 2, en particulier 2,1 ≤ n ≤ 3,0.

3. Cellule solaire selon la revendication 1,
**caractérisée en ce**
**que** la deuxième couche constituée de SiN ou contenant du SiN comporte un rapport silicium-azote de 1 à 2,2 et une concentration d'atomes H supérieure à 10 %.

4. Cellule solaire selon au moins la revendication 1,
**caractérisée en ce**
**qu'**après fabrication de la première couche, des porteurs de charge positive et/ou négative sont intercalés dans la première couche (22).

5. Cellule solaire selon au moins la revendication 4,
**caractérisée en ce**
**que** la densité de charge surfacique des porteurs de charge est supérieure à 1 · 10¹²/cm².

6. Cellule solaire selon la revendication 1,
**caractérisée en ce**
**que** sur la première couche (22), ou sur une couche isolante s'étendant sur ladite première couche, est placée une troisième couche (28) électroconductrice et au moins partiellement transparente sur le plan optique, qui, avec une disposition sur la première couche, est reliée de manière électroconductrice au contact avant (18, 20), et qui, avec une disposition sur la couche isolante, est reliée de manière électroconductrice au contact avant ou au contact arrière.

7. Cellule solaire selon au moins une des revendications précédentes,
**caractérisée en ce**
**que** la deuxième couche (26) présente une épaisseur D₂ telle que 1 nm ≤ D₂ ≤ 50 nm.

8. Cellule solaire selon au moins une des revendications précédentes,
**caractérisée en ce**
**que** la deuxième couche est en particulier une couche de SiOₓ qui est formée à partir de la zone dopée n.

9. Cellule solaire selon au moins une des revendications précédentes,
**caractérisée en ce**
**que** la deuxième couche (26) est dopée avec au moins un élément du groupe P, N, Sb, Bi, C, O, B, Al, Ga, In, Tl, Cu, V, W, Fe, Cr.

10. Cellule solaire selon au moins une des revendications précédentes,
**caractérisée en ce**
**que** la troisième couche (28) est constituée d'oxyde d'indium-étain ou d'oxyde de zinc ou en contient.

11. Cellule solaire selon au moins une des revendications précédentes,
**caractérisée en ce**
**qu'**en cas de la formation de la deuxième couche (26) à partir d'un matériau autre que SiN, la première couche présente un indice de réfraction n ≥ 2,0, ou qu'en cas de formation de la deuxième couche en SiN ou contenant du SiN, l'indice de réfraction de la première couche est inférieur à celui de la deuxième couche.

12. Cellule solaire selon au moins une des revendications précédentes,
**caractérisée en ce**
**que** la cellule solaire (10, 100, 110) présente une tension de système négative.

13. Procédé de fabrication d'une cellule solaire cristalline (10, 100, 110) avec un substrat (12) à dopage de base p, une zone avant (14) dopée n, une zone arrière (16) dopée p, des contacts avant et arrière (18, 20, 24) ainsi qu'au moins une couche frontale (22), telle qu'une couche antireflet, en tant que première couche constituée de SiN ou contenant du SiN,
**caractérisé en ce**
**qu'**entre ladite première couche (22) et la zone dopée n (14) est placée une deuxième couche (26) qui est constituée d'au moins un des matériaux du groupe SiOₓ, Al₂Oₓ, SiOₓN_{y}:H_{z}, a-Si:H, TiOₓ ou contient un tel matériau, et est dopée pour former des défauts, et qu'après la fabrication de la cellule solaire (10, 100, 110), soit une tension négative Un est appliquée à ladite cellule solaire, soit des porteurs de charge positive et/ou négative sont intercalés dans la première couche.

14. Procédé selon la revendication 13,
**caractérisé en ce**
**que** la deuxième couche (26) est dopée avec au moins un élément du groupe P, N, Sb, Bi, C, O, B, Al, Ga, In, Tl, Cu, V, W, Fe, Cr.

15. Procédé selon la revendication 13,
**caractérisé en ce**
**que** les porteurs de charge sont intercalés dans la première couche (22) sous une température T₂ telle que 10 °C ≤ T₂ ≤ 600 °C par application de charges positives sur la face avant de la cellule solaire (10, 100, 110), sachant qu'en particulier les charges positives sont appliquées sur la face avant de la cellule solaire par des décharges par effet de couronne.

16. Procédé selon la revendication 13 ou 15,
**caractérisé en ce**
**que** sous une température comprise entre 50° C et 200° C, de préférence égale à 80° C, une tension négative est appliquée à la cellule solaire (10, 100, 110) et/ou des charges positives et/ou négatives sont intercalées dans la première couche (22).

17. Procédé selon au moins la revendication 13,
**caractérisé en ce**
**qu'**à partir de la zone dopée n (14), dans une atmosphère oxygénée, sous une température T telle que 150 °C ≤ T ≤ 1000 °C et en particulier sous une pression comprise entre 10⁻⁵ bar et 0,5 bar est formée une couche de SiOₓ en tant que deuxième couche (26).

18. Procédé selon au moins la revendication 13,
**caractérisé en ce**
**que** la deuxième couche (26) est constituée sous la forme d'une couche de SiOₓ à partir de la zone dopée n (14) dans une atmosphère ozonisée ou en utilisant un liquide ozonisé.

19. Procédé selon au moins la revendication 13,
**caractérisé en ce**
**que** la deuxième couche (12), en particulier la couche de SiOₓ, est formée avec une épaisseur D₂ telle que 1 nm ≤ D₂≤ 50 nm, sachant que de préférence la deuxième couche est constituée sous forme de la couche de SiOₓ à partir de la zone dopée n (14) dans une atmosphère oxygénée au moyen d'une lumière UV d'une longueur d'onde λ telle que λ < 400 nm.
